Europäisches Patentamt

European Patent Office

Office européen des brevets

(11) Publication number: 0 334 006
A1

# (12) EUROPEAN PATENT APPLICATION

(21) Application number: 89102046.3

(22) Date of filing: 06.02.89

(51) Int. Cl.⁴: H01L 29/80 , H01L 29/10 , H01L 29/205 , H01L 27/06

(30) Priority: 22.02.88 US 158518

(43) Date of publication of application:
27.09.89 Bulletin 89/39

(84) Designated Contracting States:
DE FR GB NL

(71) Applicant: Siemens Aktiengesellschaft
Wittelsbacherplatz 2
D-8000 München 2(DE)

(72) Inventor: Kohn, Erhard
6 State Park Drive
Titusville, NJ 08560(US)
Inventor: Levy, Harold M.
61-16 Ravens Crest Drive
Plainsboro, NJ 08536(US)
Inventor: Lee, Hao
14 Cedar Court
Princeton Junction, NJ 08550(US)

(54) Stacked channel heterojunction fet.

(57) A field effect transistor comprising a high electron mobility field effect transistor (HEMT) portion and a metal-Schottky-gate field effect transistor (MESFET) portion having respective channel layers (10, 22) controlled by a common gate (26). At microwave and higher radio frequencies, the drain current capability of the HEMT portion reaches an upper limit; the MESFET portion takes over to provide drain current capability greater than this limit.

EP 0 334 006 A1

## STACKED CHANNEL HETEROJUNCTION FET

The present invention relates to field effect transistors (FET's) and, more particularly, heterojunction FET's.

FET devices, especially those utilizing gallium arsenide (GaAs) structures, find application as radio frequency (RF) amplifiers, particularly at microwave and millimeter wave frequencies. Another application for such devices is in logic elements and gates for applications in high speed digital switching. Two types of devices that are useful in such applications are the metal-semiconductor FET, more particularly the metal-Schottky-gate FET (MESFET) and the high-electron-mobility transistor (HEMT). Both types of devices are referred to in current literature such as, for example, in "Gallium Arsenide Technology", David K. Ferry, Editor-in-Chief, Howard K. Sams & Co., Inc., Indianapolis, IN; 1985.

As is recognized in the art, it generally is desirable to utilize circuits having relatively low impedances at microwave and higher frequencies and for high speed switching applications, in comparison with circuit impedances that may be conveniently utilized at lower frequencies and for low speed switching applications. Consequently, the provision of a larger amount of RF power from a semiconductor device at microwave and higher frequencies and for performing high speed switching generally means the provision of a larger RF current. Hereinafter, "RF" will be understood to include such applications.

HEMT devices are capable of providing useful RF power output. However, the performance of a HEMT is dependent on the operating power level. In a HEMT, the separation of the electron carriers in a relatively thin two dimensional electron gas (2DEG) from their donors leaves their path relatively free for easy movement. Accordingly, the electron velocity is high and so is the power gain. However, the arrangement also limits the available supply of electrons such that the RF output current is limited and hence the available RF Power output is also limited. Thus, above a certain RF power level, the transconductance and the current-gain cut-off frequency start to drop. As a result, the power output level reaches a limit. The use of multiple channels has been attempted in order to increase the current drive capability. The resulting structural arrangements are very complex. See, for example, KOHKI HIKOSAKA et al. "A30-GHz 1-W Power HEMT", IEEE Electron Device Letters, Vol. EDL-8, No. 11, November 1987. Another approach uses a superlattice gate. See D.K. Arch et al. "Superlattice conduction in superlattice modulation-doped field-effect transistors", J. APPl. Phys. 61(4), 15 February 1987, 1503-1509.

A MESFET type of device is also capable of producing useful amounts of RF power. However, it exhibits frequency dependent performance. The channel in this arrangement is impurity doped and this results in carrier scattering which reduces the transconductance and makes the noise figure worse. However, the transconductance and the current-gain cut-off frequency generally tend to increase at first with increasing power, and the RF power output available in typical a MESFET type of device generally remains relatively high beyond an RF power level at which the performance of a typical HEMT type of device has fallen appreciably. Thus, it is herein recognized that MESFET and HEMT type devices generally provide good RF performance respectively at different RF power levels, the MESFET being typically better at a higher power level.

In accordance with a first aspect of the invention, a stacked channel field effect transistor comprises a high electron mobility transistor conduction channel and a metal-Schottky-gate field effect transistor having a respective conduction channel and a gate electrode for controlling conduction therethrough, the gate electrode being disposed with respect to the high electron mobility transistor conduction channel so as to control conduction therethrough.

In accordance with a second aspect of the invention, a stacked channel field effect transistor is formed in a monolithic structure.

In accordance with a third aspect of the invention, a stacked channel field effect transistor comprises a high electron mobility field effect transistor (HEMT) portion and a metal-Schottky-gate field effect transistor (MESFET) portion having respective conduction channels controlled by a common gate. At microwave and higher radio frequencies, the drain current capability of the HEMT portion reaches an upper limit; the MESFET portion takes over to provide drain current capability greater than this limit.

In accordance with a fourth aspect of the invention, a stacked channel field effect transistor comprises a metal-Schottky-gate field effect transistor having a respective conduction channel and a control gate electrode for controlling conduction therethrough. The stacked field effect transistor further comprises a high electron mobility transistor, having a respective conduction channel disposed with respect to the control gate electrode such that conduction in the respective conduction channel of the high electron mobility transistor is controlled by the gate electrode.

In accordance with a fifth aspect of the invention, a stacked channel field effect transistor comprises a metal-Schottky-gate field effect transistor and a high electron mobility transistor having a common control gate electrode and being monolithically formed using gallium arsenide technology.

In accordance with a sixth aspect of the invention, a stacked channel field effect transistor comprises a metal-Schottky-gate field effect transistor and high electron mobility transistor having a common control gate electrode, the high electron mobility transistor having less RF channel current capability than the metal-Schottky-gate field effect transistor.

In accordance with a seventh aspect of the invention, a stacked channel field effect transistor comprises a first semiconductor layer for a conduction channel; a second semiconductor layer for a conduction channel overlying the first semiconductor layer; a doped donor layer associated with one of the first and second semiconductor layers for providing mobile carriers thereto, the other of the first and second semiconductor layers containing an impurity dopant for providing mobile carriers therein; and a gate electrode overlying one of the first and second semiconductor layers for controlling conduction in each of the first and second semiconductor channel layers.

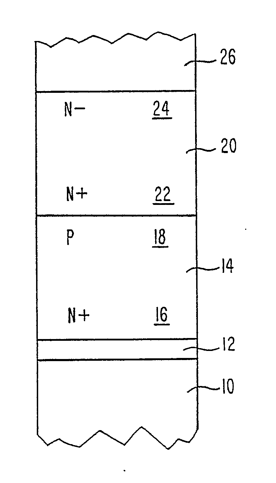

The FIGURE shows in conventional diagrammatic form, not to scale, a structure of a stacked channel field effect transistor in accordance with the invention. Source and drain contacts and other conventional details are not shown, in accordance with current conventional practice in the art.

In the embodiment shown in the FIGURE, 10 is a gallium arsenide (GaAs) buffer layer, grown on a semi-insulating GaAs substrate (not shown). Buffer layer 10 is substantially undoped. Overlying buffer layer 10 is a relatively thin spacer layer 12 of substantially undoped aluminum gallium arsenide (AlGaAs). Overlying spacer layer 12 is a doped layer 14 of AlGaAs. A portion 16 of layer 14, adjacent spacer layer 12 is relatively heavily N-doped (N+) and supplies electrons through spacer layer 12 into layer 10, thus forming a two-dimensional electron gas (2DEG) in the top portion of layer 10, adjacent spacer layer 12. This is the active conduction channel region of a high electron mobility transistor (HEMT). This separation from the supplying dopant atoms of the mobile carriers, in this case electrons, in the active channel portion of layer 10 allows these channel electrons easier movement, resulting in relatively high transit velocities with improved performance at RF, albeit up to a channel current limit at which the limited supply of channel electrons begins to have a limiting effect. The thickness of spacer layer 12 is selected in a trade-off in which greater thickness improves the separation, thus enhancing mobility but at the same time reduces electron density in the channel. It is noted that while spacer layer 12 is useful, it is not essentially needed. Region 18 of layer 14, adjacent the side remote from spacer layer 12, is P-doped. The effect of this P doping is to create an electric field urging electron transfer from layer 14 into the active channel in layer 10 and to reduce electron loss to the surface.

Overlying layer 14 is a GaAs layer 20, also referred to as a GaAs cap. Layer 20 is relatively heavily N doped (N+) in a region 22 adjacent layer 14 and relatively lightly N-doped (N-) in a region 24 adjacent the side remote from layer 14. Preferrably, the doping in region 22 is in the form of a doping "spike". Layer 20 provides a conduction channel for a metal-Schottky-gate field effect transistor (MESFET). The P-doping referred to in region 18 of layer 14 also tends to prevent electrons from being injected from the MESFET channel into layer 14 which contains a relatively high density of traps.

Overlying layer 20 and forming a Schottky diode therewith is gate metal 26 which forms the control electrode both for the MESFET and for the HEMT, the respective conduction channels of which have been described. The precise position for the gate is obtained by recess etching. Contacts (not shown) are provided for forming respective source and drain electrodes for the MESFET and HEMT. When the MESFET and HEMT channels are electrically coupled in parallel, the stacked channels subject to the control of a common gate electrode result in a device having good performance up to a high drain current capability at RF. At a power level increasing to where the performance of the HEMT drops off due to donor neutralization and the formation of a parallel "FET" in the AlGaAs, which has low electron mobility, the MESFET takes over. Thus, RF drain current capability and high cut-off frequency are maintained up to a high drain current. Eventually at higher power, the maximum RF drain current is determined by voltage breakdown of the Schottky barrier gate diode. A high breakdown diode is prefferable, for example, a "camel-diode".

In digital applications it is advantageous to have depletion mode and enhancement mode devices utilizing the same materials structure. This is achieved in the present invention by utilizing the stacked or combination MESFET-HEMT device as the depletion mode device and the HEMT, with a deeper recess, as the enhancement device

While the present invention has been explained by way of an exemplary embodiment, it will be understood that the broad nature of the invention is not limited thereby and it will be further understood by those skilled in the art that various changes and substitutions may be made without departing materially from the scope of the invention as defined by the claims following.

**Claims**

1. A stacked channel field effect transistor comprising:
a high electron mobility transistor conduction channel; and
a metal-Schottky-gate field effect transistor having a respective conduction channel and a gate electrode for controlling conduction therethrough, said gate electrode being disposed with respect to said high electron mobility transistor conduction channel so as to control conduction therethrough.

2. A stacked channel field effect transistor as recited in Claim 1 being formed in a monolithic structure.

3. A stacked channel field effect transistor as cited in Claim 2 wherein said monolithic structure utilizes gallium arsenide.

4. A stacked channel field effect transistor comprising:
a gate electrode;
a first semiconductor layer for supplying carriers;
a second semiconductor layer in proximity to said first semiconductor layer for receiving said carriers so as to form a high electron mobility transistor conduction channel therein and so disposed in relation to said gate electrode that conduction therethrough is controlled by said gate electrode; and
a third semiconductor layer so disposed in relation to said
gate electrode that conduction through a doped conduction channel therein is controlled by said gate electrode.

5. A stacked channel field effect transistor as recited in Claim 4 wherein:
said gate electrode is metal forming a Schottky barrier with a side of said third semiconductor layer:
said first semiconductor layer is of doped aluminum gallium arsenide and has one side adjacent said second semiconductor layer and one side adjacent a side of said third semiconductor layer remote from side forming said Schottky barrier;
said second semiconductor layer is of substantially undoped gallium arsenide and
said third semiconductor layer is of doped gallium arsenide.

6. A stacked channel field effect transistor as recited in Claim 5 wherein said first semiconductor layer is N-doped in a region adjacent said second semiconductor layer and said third semiconductor layer is N-doped.

7. A stacked channel field effect transistor as recited in Claim 6 wherein said first semiconductor layer is P-doped in a region adjacent said third semiconductor layer.

8. A stacked channel field effect transistor as recited in Claim 7 including a fourth layer of substantially undoped aluminum gallium arsenide, substantially thinner than said first and second layers and interposed therebetween.

9. A stacked channel field effect transistor as recited in Claim 5 wherein said conduction channel in said third semiconductor layer has greater RF current capability than said high electron mobility transistor conduction channel.

10. A stacked channel field effect transistor as recited in Claim 6 wherein said conduction channel in said third semiconductor layer has greater RF current capability than said high electron mobility transistor conduction channel.

11. A stacked channel field effect transistor as recited in Claim 7 wherein said conduction channel in said third semiconductor layer has greater RF current capability than said high electron mobility transistor conduction channel.

12. A stacked channel field effect transistor as recited in Claim 8 wherein said conduction channel in said third semiconductor layer has greater RF current capability than said high electron mobility transistor conduction channel.

13. A stacked channel field effect transistor as recited in Claim 9 wherein said conduction channel in said third semiconductor layer has greater RF current capability than said high electron mobility transistor conduction channel.

14. A stacked channel field effect transistor comprising:
a metal-Schottky-gate field effect transistor having a respective conduction channel and a control gate electrode for controlling conduction therethrough; and
a high electron mobility transistor, having a respective conduction channel disposed with respect to said control gate electrode such that conduction in said respective conduction channel of said high electron mobility transistor is controlled by said gate electrode.

15. A stacked channel field effect transistor as recited in Claim 14 wherein said metal-Schottky-gate field effect transistor and said high electron mobility transistor are nonolithically formed using gallium arsenide technology.

16. A stacked channel field effect transistor as recited in Claim 15 wherein said metal-Schottky-gate field effect transistor has greater RF channel current capability than said high electron mobility transistor.

17. A stacked channel field effect transistor comprising:

a first semiconductor layer for a conduction channel;

a second semiconductor layer for a conduction channel, said second semiconductor layer overlying said first semiconductor layer;

a doped donor layer associated with one of said first and second semiconductor layers for providing mobile carriers thereto for forming a respective conduction channel therein, the other of said first and second semiconductor layers containing an impurity dopant for providing mobile carriers therein for forming a respective conduction channel therein; and

gate electrode means overlying one of said first and second semiconductor layers for controlling conduction in each of said respective conduction channels formed in each of said first and second semiconductor layers.

18. In a composite field effect transistor, a layered arrangement comprising:

a first layer, being of gallium arsenide;

a second layer, being of aluminum gallium arsenide, overlying said first layer, and having a region thereof of a first conductivity type proximate to said first layer and a region thereof of a second conductivity type distal from said first layer;

a third layer, being of gallium arsenide, overlying said second layer, and having a relatively heavily doped region thereof of said first conductivity type proximate said second layer; and

metal gate means overlying said third layer.

19. A layered arrangement as recited in Claim 18 including a spacer layer of aluminum gallium arsenide interposed between said first and second layers.

20. A layered arrangement as recited in Claim 19 wherein said spacer layer is relatively thin compared with said second and third layers.

21. A layered arrangement as recited in Claim 20 wherein said first layer and said spacer layers are substantially undoped.

22. A layered arrangement as recited in Claim 21 wherein said layers are epitaxially grown.

23. A composite field effect transistor comprising a high electron mobility transistor and a metal-Schottky-gate field effect transistor, each of said high electron mobility transitor and said metal-Schottky-gate transistor including a respective conduction channel, said composite field effect transistor comprising:

a first layer, being of substantially undoped gallium arsenide;

a second layer, being of substantially undoped aluminum gallium arsenide, overlying said first layer;

a third layer, being of aluminum gallium arsenide, overlying said second layer and having a first, relatively highly doped, region of a first conductivity type proximate to said second layer and having a second, doped, region of a second conductivity type, distal from said second layer, said first region supplying carriers to said first layer to form a two-dimensional electron gas for forming said respective conduction channel of said high electron mobility transistor therein by modulation doping, said second layer being relatively thin compared with said third layer so as to act as a spacer between said first and third layers such that said carriers are supplied therethrough, and said second, doped region of said second conductivity type creating an electric field such as to urge said carriers to be supplied to said first layer and such as to reduce a tendency for said carriers to move in a direction away from said first layer;

a fourth layer, being of gallium arsenide, overlying said third layer, having a first, relatively highly doped, region of said first conductivity type proximate to said third layer and having a second, relatively lightly doped, region of said first conductivity type distal from said third layer for having formed therein said respective conduction channel of said metal-Schottky-gate field effect transistor; and

gate means overlying said fourth layer for controlling conduction in each of said respective conduction channels.

24. A composite field effect transistor as recited in Claim 23 wherein said first conductivity type is N and said second conductivity type is P.

25. A composite field effect transistor as recited in Claim 24 wherein said gate means comprises a metal gate electrode.

26. A composite field effect transistor as recited in Claim 23 wherein said respective conduction channels are electrically coupled in parallel between respective source and drain connections.

27. A composite field effect transistor as recited in Claim 24 wherein said respective conduction channels are electrically coupled in parallel between respective source and drain connections.

28. A composite field effect transistor as recited in Claim 25 wherein said respective conduction channels are electrically coupled in parallel between respective source and drain connections.

| | |
|---|---|
| N− | 24 |
| N+ | 22 |
| P | 18 |
| N+ | 16 |

26

20

14

12

10

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 246 641 (NEC CORP.)<br>* Page 4, column 5, line 20 - page 5, column 7, line 14; figures 1-3 * | 1-3,14, 15,17 | H 01 L 29/80<br>H 01 L 29/10<br>H 01 L 29/205<br>H 01 L 27/06 |
| A | | 4-6,18, 23-28 | |
| A | EP-A-0 119 089 (FUJITSU LTD)<br>* Page 10, line 17 - page 11, line 25; page 14, line 24 - page 15, line 10; figure 12 * | 1-6,8, 14,15, 17-28 | |
| D,A | J. APPL. PHYS., vol. 61, no. 4, 15th February 1987, pages 1503-1509, American Institute of Physics; D.K. ARCH et al.: "Superlattice conduction in superlattice modulation-doped field-effect transistors"<br>* Whole document * | 1-5,8, 14,15, 17-28 | |
| A | EP-A-0 255 416 (THOMSON-CSF)<br>* Page 3, column 3, line 14 - column 4, line 16; page 3, column 4, line 39 - page 4, column 6, line 28; figures 1,3a,3b,4 * | 1-5,8, 14,15, 17-28 | TECHNICAL FIELDS SEARCHED (Int. Cl.4)<br><br>H 01 L |

The present search report has been drawn up for all claims

| Place of search | Date of completion of the search | Examiner |
|---|---|---|
| THE HAGUE | 27-05-1989 | MORVAN D.L.D. |